# FASCICULE DE BREVET EUROPEEN

(11) **EP 0 708 528 B1**
(45) Date de publication et mention de la délivrance du brevet: **01.03.2000**
(21) Numéro de dépôt: 95202723.3
(22) Date de dépôt: 10.10.1995
(51) Int. Cl.: H03J 1/00

(54) **Récepteur de radio à recherche automatique des stations**
Radioempfänger mit automatischem Sendersuchlauf
Radio receiver with automatic searching of stations

(30) Priorité: 19.10.1994 FR 9412488
(43) Date de publication de la demande: 24.04.1996
(73) Titulaire: Koninklijke Philips Electronics N.V., 5621 BA Eindhoven (NL)
(72) Inventeur: Grenier, André, F-75008 Paris (FR); Chenais, Jean-Yves, F-75008 Paris (FR)
(74) Mandataire: Charpail, François

(56) Documents cités:
- WO-A-93/23963
- GB-A- 2 006 577
- US-A- 5 262 769

## Description

La présente invention concerne un récepteur de radio muni de moyens d'enregistrement de présélections pour réaliser un balayage d'une gamme de fréquences de réception et pour, au cours de ce balayage, évaluer les conditions de réception de chaque station reçue et enregistrer dans une mémoire des données concernant les stations qui peuvent être reçues dans les meilleures conditions de réception.

Un récepteur correspondant au préambule ci-dessus est connu du document DE-OS-38 07 724 (Eben). Selon ce document, pour enregistrer dans une mémoire permanente des caractéristiques des stations reçues dans les meilleures conditions de réception, un dispositif mémorise les valeurs de champ pour chaque fréquence puis effectue un tri pour les classer par ordre de valeur de champ, et attribue enfin à des touches de présélection les données permettant de retrouver les réceptions les plus fortes.

Avec les récepteurs connus, on peut craindre que l'enregistrement des caractéristiques pour chaque fréquence, suivi d'un tri, ne réclame un temps de traitement excessif. Dans le but d'accélérer le processus dans son ensemble, une première forme de réalisation d'un récepteur selon l'invention est remarquable en ce que le récepteur est muni en outre
- de moyens pour engendrer un balayage "de dégrossissage" au cours duquel est réalisé un comptage du nombre des stations dont l'intensité de champ dépasse un seuil prédéterminé dit seuil de comptage, sans enregistrement des caractéristiques individuelles de ces stations, ce balayage de dégrossissage étant réalisé avant que les moyens d'enregistrement de présélections réalisent le balayage avec enregistrement des données concernant les stations reçues,
- et de moyens de détermination d'une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions, ces moyens de détermination déterminant le seuil de sélection en fonction du nombre des stations dont l'intensité de champ dépasse le seuil de comptage, sur la base d'une comparaison avec des valeurs d'une base de données obtenue préalablement à partir de relevés expérimentaux,
et en ce que les moyens d'enregistrement de présélections sont agencés de façon à enregistrer les caractéristiques des stations dont l'intensité de champ dépasse le seuil de sélection.
Dans le même but, une seconde forme de réalisation d'un récepteur selon l'invention est remarquable en ce que le récepteur est muni en outre
- de moyens pour engendrer un balayage de dégrossissage au cours duquel sont réalisés simultanément plusieurs comptages, chacun de ces comptages comptant le nombre des stations dont l'intensité de champ dépasse un seuil prédéterminé dit seuil de comptage, différent pour chacun des comptages, sans enregistrement des caractéristiques individuelles de ces stations, ce balayage de dégrossissage étant réalisé avant que les moyens d'enregistrement de présélections réalisent le balayage avec enregistrement des caractéristiques des stations reçues,
- et de moyens pour déterminer, sur la base des nombres décomptés lors du balayage de dégrossissage, par choix d'une valeur de seuil de comptage correspondant à un nombre de réceptions désiré, ou par interpolation entre deux valeurs de seuil de comptage encadrant ce nombre, une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions,
et en ce que les moyens d'enregistrement de présélections sont agencés de façon à enregistrer les caractéristiques des stations dont l'intensité de champ dépasse le seuil de sélection.

L'invention est donc basée sur l'idée que le gain de temps obtenu sur la durée du balayage d'enregistrement de présélections de l'art antérieur, grâce au travail réalisé au cours d'un premier balayage de dégrossissage, pourrait être tel que le temps global des deux balayages à la suite serait en fin de compte plus court.
Les moyens pour engendrer un balayage de dégrossissage étant agencés pour provoquer des sauts de fréquence discrets de grandeur prédéterminée, un perfectionnement consiste en ce que ils sont agencés en outre pour déclencher un saut plus grand lorsqu'une réception dont l'intensité de champ dépasse une valeur prédéterminée vient d'être détectée.
Ainsi le balayage de dégrossissage dure moins longtemps. Dans un récepteur de radio selon l'invention, comportant un circuit de mesure qui délivre sous forme d'une valeur numérique un signal indiquant l'intensité de champ de réception instantanée, et muni d'un processeur numérique avec une mémoire et muni d'un logiciel, ce dernier est avantageusement agencé
- pour engendrer des valeurs successives de syntonisation du récepteur constituant des pas de fréquence de réception et couvrant une gamme de fréquences de réception,
- pour vérifier à chaque pas si la dite valeur numérique d'intensité de champ est plus grande qu'un seuil prédéterminé dit seuil de comptage,
- pour compter le nombre de cas où ceci se produit, et pour enregistrer ce nombre,
- pour déterminer, en fonction de ce nombre, une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions,
- pour engendrer à nouveau des valeurs successives de syntonisation du récepteur constituant des pas de fréquence de réception couvrant la gamme de fréquences de réception, et pour enregistrer alors les données concernant les stations dont l'intensité de champ dépasse le seuil de sélection.

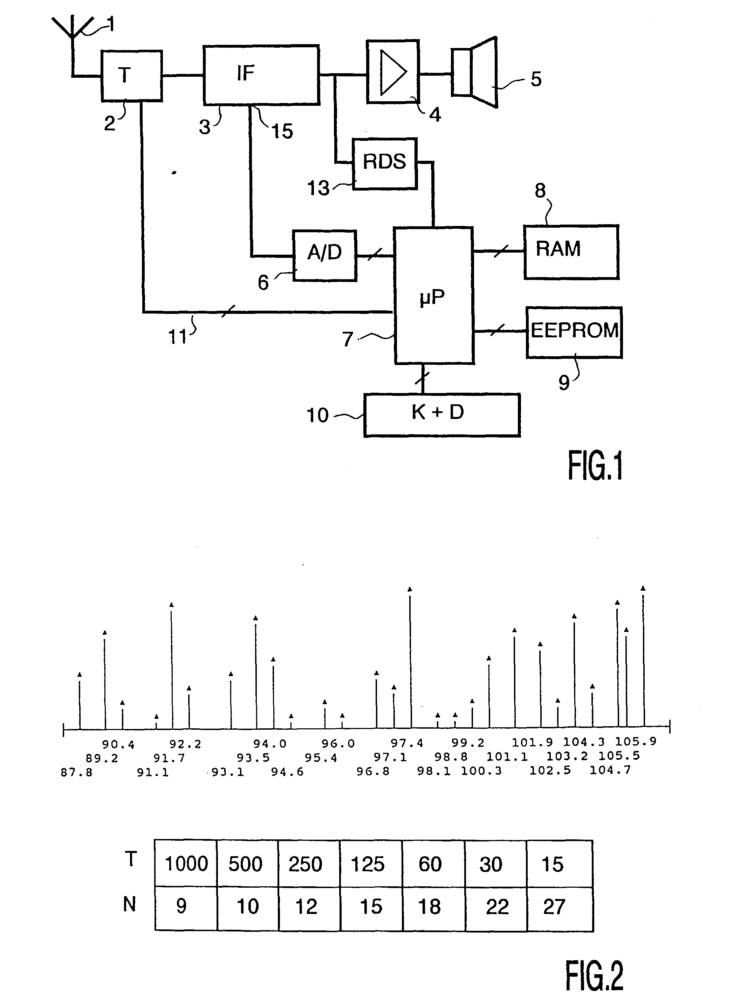

Ces aspects de l'invention ainsi que d'autres aspects plus détaillés apparaîtront plus clairement grâce à la description suivante d'un mode de réalisation non limitatif. La figure 1 représente schématiquement les éléments habituels d'un récepteur radio moderne, grâce auxquels l'invention peut être mise en oeuvre.
La figure 2 représente un résultat de wobbulation des stations reçues à un instant donné, avec un tableau de relevés, illustrant le processus mis en oeuvre avec l'invention.

Le récepteur de la figure 1 comporte, à partir d'une antenne 1, un élément 2 de type connu contenant un circuit de syntonisation et un circuit de changement de fréquence ("tuner"), suivi d'un élément 3 également de type connu contenant un amplificateur à fréquence intermédiaire et un démodulateur. La sortie de signal démodulé de l'élément 3 alimente un amplificateur audio 4 suivi d'un haut-parleur 5. Dans les récepteurs modernes, on trouve aussi un microprocesseur 7 qui a de multiples rôles. Il est relié notamment :
- à un élément 10 comprenant un clavier de commande à la disposition de l'utilisateur, et un écran d'affichage, par exemple à cristaux liquides.
- à une mémoire volatile 8 dite "RAM", pour le stockage d'éléments provisoires tels que des valeurs de calcul transitoires ou en général les valeurs que l'on ne souhaite pas conserver lorsque le contact du véhicule est coupé,
- à une mémoire permanente 9 de type dit "EEPROM", pour le stockage d'éléments définitifs ou momentanément définitifs, tels que les caractéristiques de stations que l'on désire pouvoir rappeler un jour ou l'autre.
Dans un procédé dit RDS ("Radio Data System"), maintenant bien connu, une sous-porteuse FM est modulée par des signaux numériques de données utiles à la réception des différents émetteurs d'une même chaîne. Un décodeur 13 de messages RDS est présent ici, dont les données RDS sont amenées au microprocesseur 7 pour être analysées et éventuellement mémorisées.
L'élément 3 contenant un amplificateur à fréquence intermédiaire et un démodulateur est d'un type qui fournit, sur une sortie prévue à cet effet, un signal analogique indiquant l'intensité de champ de réception. On peut citer par exemple le modèle référencé TDA 1576T vendu sous la marque "Philips", qui est un amplificateur / démodulateur fournissant un tel signal sur sa sortie numéro 15.
A la sortie 15 de l'élément 3 est connecté un convertisseur analogique / numérique 6, dont la sortie numérique est connectée à une entrée du microprocesseur 7.
Le microprocesseur 7 est muni d'un élément de logiciel qui lui permet de fournir des valeurs numériques qui sont appliquées via une connexion 11 à une entrée de l'élément 2 pour sélectionner une fréquence de réception. On suppose donc que la fréquence de réception de l'élément 2 est ajustable au moyen d'une entrée de signal numérique. Si l'entrée d'ajustement de fréquence était prévue pour un signal analogique, il suffirait d'insérer un convertisseur numérique/analogique dans la connexion 11.
L'élément de logiciel en question est agencé pour générer à la demande des sauts de fréquence discrets de grandeur prédéterminée qui ont pour effet de balayer pas à pas la gamme FM allant de 87.7 à 108 Mhz, par exemple par sauts ou "pas" de 0.1 Mhz.
Les conditions de réception sont évaluées à l'aide de la mesure de champ (15, 6) et éventuellement, à titre de confirmation pendant le balayage destiné à enregistrer les données concernant les stations, à l'aide du décodeur RDS 13, qui peut aider à évaluer la qualité de réception, par exemple par le fait que l'on reçoive ou non un message RDS correct.
Un autre élément de logiciel est présent, qui doit être utilisé avant l'élément décrit ci-dessus. Cet autre élément de logiciel est lui aussi agencé pour générer, à la demande, des sauts de fréquence discrets de grandeur prédéterminée qui ont pour effet de balayer pas à pas la gamme FM allant de 87.7 à 108 Mhz, par exemple par sauts ou "pas" de 0.1 Mhz. Une position en mémoire est prévue pour enregistrer une valeur prédéterminée exprimant un seuil de comptage, et une autre position en mémoire est prévue pour enregistrer un résultat de comptage, par exemple dans un registre qui peut, grâce à une instruction de programmation élémentaire, être incrémenté d'une unité.
Le registre prévu pour contenir le résultat de comptage est remis à zéro au début du balayage. Au cours de ce balayage, l'élément de logiciel teste à chaque pas si le niveau de réception, fourni par le convertisseur 6, dépasse le seuil de comptage, et dans ce cas incrémente le contenu du registre. A l'instant où ceci se produit, il est avantageux que la valeur du pas suivant soit augmentée, de façon à valoir par exemple 0,3 MHz, au lieu de 0,1 MHz : en effet si un émetteur puissant vient d'être détecté, il est improbable qu'un autre se trouve sur une fréquence voisine. En sautant des pas, le processus de balayage est accéléré.

Une manière de déduire un seuil de sélection "Ss" à partir du nombre de réceptions trouvées, ainsi que la bonne valeur à utiliser pour le seuil de comptage, peut être déterminée par une expérimentation relativement simple. Des essais peuvent démontrer par exemple qu'avec une valeur de seuil de comptage de 100 µV (µV = microvolts), si l'on trouve une vingtaine de réceptions de niveau plus élevé que les 100 µV en question, cela signifie qu'on est actuellement dans une grande agglomération, et que le seuil de sélection doit alors être choisi égal à 500 µV, alors que si, au contraire, on ne trouve que trois réceptions de niveau plus élevé que les 100 µV en question, cela signifie qu'on est dans une zone "pauvre", et le seuil de sélection peut être fixé par exemple à 15 µV. Les expérimentations décrites ci-dessus, doivent être réalisées avant la programmation du présent microprocesseur.
Encore un autre élément de logiciel est ainsi présent pour déterminer, sur la base des résultats des expérimentations décrites ci-dessus, en fonction du résultat du comptage du moment, une valeur de seuil dite de sélection destinée à être utilisée par la suite pour choisir celles des stations dont les données seront enregistrées dans la mémoire.
Par exemple, la mémoire EEPROM 9 peut contenir un tableau dans lequel sont enregistrés des données résultant des expériences, tableau dans lequel on entre par le nombre de réceptions trouvé, et qui fournit en réponse la valeur du seuil de sélection. On peut aussi prévoir un élément de logiciel qui engendre une série de tests de type connu, du genre : "si N>x₁ alors Ss = m₁ , si N>x₂ alors Ss = m₂ , si N>x₃ alors Ss = m₃ , si N>x₄ alors Ss = m₄ , etc" (N= nombre de réception décomptées, Ss = seuil de sélection à mettre en oeuvre, xᵢ et mᵢ étant les valeurs déterminées par l'expérimentation).
Selon une mise en oeuvre plus élaborée, qui permet d'obtenir des résultats plus fiables, le logiciel de dégrossissage est associé à :
- plusieurs positions en mémoire EEPROM, par exemple sept positions, qui sont prévues pour enregistrer chacune une valeur prédéterminée exprimant un seuil de comptage,
- et sept autres position en mémoire RAM, qui sont prévues pour enregistrer les résultats de comptages correspondant aux sept seuils de comptage. Ces positions sont bien entendu mises à zéro au début du balayage.
Chaque fois qu'un pas de fréquence est franchi et qu'une valeur de niveau de réception est disponible à la sortie du convertisseur 6, le logiciel réalise la comparaison de cette valeur avec chacune des sept valeurs de seuil de comptage, et incrémente les résultats de comptage correspondant aux seuils de comptage qui ont été dépassés. En même temps, il est avantageux que la valeur du pas suivant soit augmentée, de façon à valoir par exemple 0,3 MHz au lieu de 0,1 MHz, si un seuil donné, par exemple de 125 µV, a été dépassé.
La figure 2 illustre le processus mis en oeuvre. En haut de la figure est présenté sous la forme d'une wobbulation l'ensemble des signaux que l'on peut recevoir, l'intensité de champ de chacun d'eux étant indiquée par la longueur du trait vertical correspondant. La fréquence est indiquée à chaque fois par un chiffre en dessous de l'axe horizontal.
En dessous, le tableau montre ce qui, à l'issue du balayage de fréquence, est présent dans les deux fois sept mémoires : dans la ligne du haut du tableau (T), les valeurs des seuils de comptage, et dans la ligne du bas, les résultats des comptages donnant le nombre de réceptions dont le niveau, fourni par le convertisseur 6, dépasse le seuil de comptage indiqué au dessus dans le tableau.
Un seuil de sélection "Ss" peut être déterminé, à partir de ces multiples nombres de réceptions trouvées, de façon moins aléatoire qu'avec un seul nombre de réceptions relevées pour un seul seuil de comptage. Supposons par exemple que l'on désire pouvoir rappeler par la suite les dix stations les plus puissantes, c'est-à-dire que la capacité d'enregistrement des stations présélectionnées est de dix stations. Il se trouve que dans le cas présent le cas "dix réceptions" est obtenu très précisément avec le seuil de 500 µV : ce sera donc le seuil de sélection choisi. L'élément de logiciel prévu pour déterminer, sur la base des résultats des comptages, la valeur de seuil de sélection est agencé de façon à, par exemple, réaliser une règle de trois entre les seuils de comptage ayant conduit à un nombre de réceptions respectivement plus grand et plus petit que dix, au cas où le nombre de dix ne serait pas trouvé exactement pour l'un des seuils de comptage. Une exploration par seuils croissants est possible également, le seuil de sélection choisi finalement étant égal au seuil de comptage pour lequel le nombre de comptages devient inférieur ou égal à dix. Dans le cas présent on rencontrera ainsi successivement comme valeurs du nombre de stations relevées : 27, 22, 18, 15, 12, 10 et à ce moment le processus s'arrêtera en choisissant un seuil de sélection de 500 µV. Bien entendu il se pourrait, avec cette méthode, que dans d'autres conditions de réception, le nombre d'émetteurs obtenu soit légèrement inférieur à dix. Cela vaudrait mieux que l'inverse, car si un seuil de sélection était choisi qui conduise par exemple à douze réceptions, et qu'on enregistre seulement les dix premières, il se pourrait que l'on manque une ou deux des meilleures réceptions puisqu'elles ne sont pas classées dans l'ordre des puissances de réception.

## Revendications

1. Récepteur de radio muni de moyens d'enregistrement de présélections pour réaliser un balayage d'une gamme de fréquences de réception et pour, au cours de ce balayage, évaluer les conditions de réception de chaque station reçue et enregistrer dans une mémoire des données concernant les stations qui peuvent être reçues dans les meilleures conditions de réception,
caractérisé en ce qu'il est muni en outre
- de moyens pour engendrer un balayage "de dégrossissage" au cours duquel est réalisé un comptage du nombre des stations dont l'intensité de champ dépasse un seuil prédéterminé dit seuil de comptage, sans enregistrement des caractéristiques individuelles de ces stations, ce balayage de dégrossissage étant réalisé avant que les moyens d'enregistrement de présélections réalisent le balayage avec enregistrement des données concernant les stations reçues,
- et de moyens de détermination d'une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions, ces moyens de détermination déterminant le seuil de sélection en fonction du nombre des stations dont l'intensité de champ dépasse le seuil de comptage, sur la base d'une comparaison avec des valeurs d'une base de données obtenue préalablement à partir de relevés expérimentaux,
et en ce que les moyens d'enregistrement de présélections sont agencés de façon à enregistrer les caractéristiques des stations dont l'intensité de champ dépasse le seuil de sélection.

2. Récepteur de radio muni de moyens d'enregistrement de présélections pour réaliser un balayage d'une gamme de fréquences de réception et pour, au cours de ce balayage, évaluer les conditions de réception de chaque station reçue et enregistrer dans une mémoire des données concernant les stations qui peuvent être reçues dans les meilleures conditions de réception,
caractérisé en ce qu'il est muni en outre
- de moyens pour engendrer un balayage "de dégrossissage" au cours duquel sont réalisés simultanément plusieurs comptages, chacun de ces comptages comptant le nombre des stations dont l'intensité de champ dépasse un seuil prédéterminé dit seuil de comptage, différent pour chacun des comptages, sans enregistrement des caractéristiques individuelles de ces stations, ce balayage de dégrossissage étant réalisé avant que les moyens d'enregistrement de présélections réalisent le balayage avec enregistrement des caractéristiques des stations reçues,
- et de moyens pour déterminer, sur la base des nombres décomptés lors du balayage de dégrossissage, par choix d'une valeur de seuil de comptage correspondant à un nombre de réceptions désiré, ou par interpolation entre deux valeurs de seuil de comptage encadrant ce nombre, une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions,
et en ce que les moyens d'enregistrement de présélections sont agencés de façon à enregistrer les caractéristiques des stations dont l'intensité de champ dépasse le seuil de sélection.

3. Récepteur de radio selon l'une des revendications 1 ou 2, dont les moyens pour engendrer un balayage de dégrossissage sont agencés pour provoquer des sauts de fréquence discrets de grandeur prédéterminée, caractérisé en ce qu'ils sont agencés en outre pour déclencher un saut plus grand lorsqu'une réception dont l'intensité de champ dépasse une valeur prédéterminée vient d'être détectée.

4. Récepteur de radio selon l'une quelconque des revendications précédentes, comportant un circuit de mesure qui délivre sous forme d'une valeur numérique un signal indiquant l'intensité de champ de réception instantanée, et muni d'un processeur numérique avec une mémoire, muni d'un logiciel,
caractérisé en ce que le logiciel est agencé
- pour engendrer des valeurs successives de syntonisation du récepteur constituant des pas de fréquence de réception et couvrant une gamme de fréquences de réception,
- pour vérifier à chaque pas si la dite valeur numérique d'intensité de champ est plus grande qu'un seuil prédéterminé dit seuil de comptage,
- pour compter le nombre de cas où ceci se produit, et pour enregistrer ce nombre,
- pour déterminer, en fonction de ce nombre, une valeur d'un seuil dit seuil de sélection destiné à être utilisé par la suite comme critère de sélection de celles des stations dont les données doivent être enregistrées dans la mémoire, dans le but de réaliser l'enregistrement d'un nombre limité de stations reçues dans les meilleures conditions,
- pour engendrer à nouveau des valeurs successives de syntonisation du récepteur constituant des pas de fréquence de réception couvrant la gamme de fréquences de réception, et pour enregistrer les données concernant les stations dont l'intensité de champ dépasse le seuil de sélection.

## Patentansprüche

1. Die vorliegende Erfindung betrifft einen Radioempfänger mit Aufzeichnungsmitteln von Festsendern zur Durchführung einer Frequenzbereichsabtastung und, im Laufe dieser Abtastung, zur Bewertung der Empfangsbedingungen jedes empfangenen Senders und zum Aufzeichnen in einem Speicher der Daten bezüglich der Sender, die unter den besten Empfangsbedingungen empfangen werden können,
dadurch gekennzeichnet, daß er zusätzlich versehen ist mit
- Mitteln zur Vornahme eines "Grobabtastens", bei dem ein Zählen der Anzahl Sender vorgenommen wird, deren Feldstärke einen vorbestimmten Grenzwert überschreitet, der Zählgrenze bezeichnet wird, ohne Aufzeichnung der einzelnen Merkmale dieser Sender, wobei dieses Grobabtasten durchgeführt wird, bevor die Aufzeichnungsmittel der Festsender das Abtasten und Aufzeichnen der Daten bezüglich der empfangenen Sender vornehmen, und mit
- Mitteln zur Bestimmung eines Grenzwertes, der Auswahlgrenze bezeichnet wird und dazu dient, danach als Auswahlkriterium für die Sender verwendet zu werden, deren Daten im Speicher aufzuzeichnen sind, mit dem Ziel, eine Aufzeichnung einer begrenzten Anzahl Sender unter besten Bedingungen vorzunehmen, wobei diese Bestimmungsmittel die Auswahlgrenze unter Berücksichtigung der Anzahl Sender bestimmen, deren Feldstärke die Zählgrenze überschreitet, auf der Grundlage eines Vergleichs mit den Werten einer zuvor auf Grundlage von Versuchsergebnissen erhaltenen Datenbank,
und dadurch, daß die Mittel zum Aufzeichnen der Festsender angeordnet sind, um die Merkmale der Sender aufzuzeichnen, deren Feldstärke die Auswahlgrenze überschreitet.

2. Radioempfänger mit Aufzeichnungsmitteln von Festsendern zur Durchführung einer Frequenzbereichsabtastung und, im Laufe dieser Abtastung, zur Bewertung der Empfangsbedingungen jedes empfangenen Senders und zum Aufzeichnen in einem Speicher der Daten bezüglich der Sender, die unter den besten Empfangsbedingungen empfangen werden können,
dadurch gekennzeichnet, daß er zusätzlich versehen ist mit
- Mitteln zur Vornahme eines "Grobabtastens", bei dem gleichzeitig mehrere Zählungen vorgenommen werden, wobei jede der Zählungen die Anzahl Sender zählt, deren Feldstärke einen vorbestimmten Grenzwert überschreitet, der Zählgrenze bezeichnet wird und für jede der Zählungen unterschiedlich ist, ohne Aufzeichnung der einzelnen Merkmale dieser Sender, wobei dieses Grobabtasten durchgeführt wird, bevor die Aufzeichnungsmittel der Festsender das Abtasten und Aufzeichnen der Daten bezüglich der empfangenen Sender vornehmen, und
- auf der Grundlage der beim Grobabtasten gezählten Anzahl über die Wahl eines Zählgrenzwertes entsprechend einer Anzahl gewünschter Sender oder über Interpolation zwischen zwei diese Anzahl eingrenzenden Zählgrenzwerten mit Mitteln zur Bestimmung eines Grenzwertes, der Auswahlgrenze bezeichnet wird und dazu dient, danach als Auswahlkriterium für die Sender verwendet zu werden, deren Daten im Speicher aufzuzeichnen sind, mit dem Ziel, eine Aufzeichnung einer begrenzten Anzahl Sender unter besten Bedingungen vorzunehmen,
und dadurch, daß die Mittel zum Aufzeichnen der Festsender angeordnet sind, um die Merkmale der Sender aufzuzeichnen, deren Feldstärke die Auswahlgrenze überschreitet.

3. Radioempfänger nach einem der Ansprüche 1 oder 2, wobei die Mittel zur Vornahme einer Grobabtastung angeordnet sind, um diskrete Frequenzsprünge vorbestimmter Größe zu verursachen, dadurch gekennzeichnet, daß sie zudem angeordnet sind, um bei der Erfassung eines Empfangs, dessen Feldstärke einen vorbestimmten Wert übersteigt, einen größeren Sprung vorzunehmen. So dauert das Grobabtasten weniger lange.

4. Radioempfänger nach einem beliebigen der vorhergehenden Ansprüche, mit einer Meßschaltung, die in der Form eines digitalen Werts ein Signal abgibt, das die momentane Empfangsfeldstärke angibt, und mit einem digitalen Prozessor mit einem Speicher versehen, mit einer Software versehen, ist diese letztere vorzugsweise angeordnet, um
- aufeinanderfolgende Werte der Empfängerabstimmung als Empfangsfrequenzschritte zu erzeugen, die einen Empfangsfrequenzbereich abdecken,
- bei jedem Schritt zu prüfen, ob der sogenannte digitale Felddichtewert über einer vorbestimmten Grenze, der sogenannten Zählgrenze liegt,
- die Anzahl Fälle zu zählen, bei denen dies vorkommen und diese Zahl aufzuzeichnen,
- unter Berücksichtigung dieser Zahl einen Grenzwert zu bestimmen, die sogenannte Auswahlgrenze, die daraufhin zur Verwendung als Auswahlkriterium der Sender bestimmt ist, die im Speicher aufzuzeichnen sind, mit dem Ziel, die Aufzeichnung einer begrenzten Anzahl Sender vorzunehmen, die unter den besten Bedingungen empfangen werden können,
- erneut aufeinanderfolgende Werte der Empfängerabstimmung als Empfangsfrequenzschritte zu erzeugen, die einen Empfangsfrequenzbereich abdecken, und dann die Daten bezüglich der Sender aufzuzeichnen, deren Feldstärke die Auswahlgrenze übersteigt.

## Claims

1. A radio receiver comprising means for the storage of preselections in order to scan a reception frequency range and, during this scan, to evaluate the receiving conditions of each station received and to store in a memory data relating to the stations which can be received under the best receiving conditions,
characterized in that it further comprises
- means for effecting a "coarse" scan during which the number of stations is counted whose field strength exceeds a given threshold called counting threshold, without the individual characteristics of these stations being stored, which coarse scan is effected before the preselection storage means effect the scan with storage of the data relating to the received stations, and
- means for determining a value of a threshold called selection threshold intended for subsequent use as a criterion for the selection of those stations whose data is to be stored in the memory, in order to achieve the storage of a limited number of stations received under the best conditions, said determining means determining the selection threshold as a function of the number of stations whose field strength exceeds the counting threshold, on the basis of a comparison with values of a data base obtained previously by means of experimental measurements,
and in that the preselection storage means are adapted to store the characteristics of stations whose field strengths exceeds the selection threshold.

2. A radio receiver comprising means for the storage of preselections in order to scan a reception frequency range and, during this scan, to evaluate the receiving conditions of each station received and to store in a memory data relating to the stations which can be received under the best receiving conditions,
characterized in that it further comprises
- means for effecting a "coarse" scan during which a plurality of counting operations are effected simultaneously, each of these counting operations counting the number of stations whose field strength exceeds a given threshold called counting threshold, which is different for each of the counting operations, without the individual characteristics of these stations being stored, which coarse scan is effected before the preselection storage means effect the scan with storage of the data relating to the received stations, and
- means for determining, on the basis of the numbers counted during the coarse scan, a value of a threshold called selection threshold by choosing a counting threshold value corresponding to a desired number of receptions, or by interpolation between two counting threshold values bordering on this number, which selection threshold is intended for subsequent use as a criterion for the selection of those stations whose data is to be stored in the memory, in order to achieve the storage of a limited number of stations received under the best conditions,
and in that the preselection storage means are adapted to store the characteristics of stations whose field strengths exceeds the selection threshold.

3. A radio receiver as claimed in Claim 1 or 2, whose means for effecting a coarse scan are adapted to produce discrete frequency steps of given magnitude, characterized in that they are further adapted to produce a larger step when a reception whose field strength exceeds a given value has just been detected.

4. A radio receiver as claimed in any one of the preceding Claims, including a measurement circuit which supplies a signal in the form of a digital value indicating the instantaneous reception field strength, and provided with a digital processor having a memory loaded with a program,
characterized in that the program is configured
- to generate successive values for the tuning of the receiver, which values form reception frequency steps and cover a reception frequency range,
- to verify for each step if said digital field-strength value exceeds a given threshold called counting threshold,
- to count the number of cases where this occurs and to store this number,
- to determine, as function of this number, a value of a threshold called selection threshold intended for subsequent use as a criterion for the selection of those stations whose data is to be stored in the memory, in order to achieve the storage of a limited number of stations received under the best conditions,
- to generate again successive values for the tuning of the receiver, which values form reception frequency steps and cover a reception frequency range, and to store the data relating to the stations whose field strength exceeds the selection threshold.
